# FASCICULE DE BREVET EUROPEEN

(11) **EP 2 509 402 B1**
(45) Date de publication et mention de la délivrance du brevet: **19.06.2013**
(21) Numéro de dépôt: 12158014.6
(22) Date de dépôt: 05.03.2012
(51) Int. Cl.: H05K 7/14, H05K 7/20

(54) **Variateur de vitesse à architecture optimisée**
Drehzahlregler mit optimierter Architektur
Variable speed drive with optimized architecture

(30) Priorité: 04.04.2011 FR 1152851
(43) Date de publication de la demande: 10.10.2012
(73) Titulaire: Schneider Toshiba Inverter Europe SAS, 27120 Pacy sur Eure (FR)
(72) Inventeur: Leon, Frédéric, 27810 Marcilly sur Eure (FR)
(74) Mandataire: Bié, Nicolas

(56) Documents cités:
- WO-A1-2008/071192
- US-A1- 2009 016 018

## Description

### Domaine technique de l'invention

La présente invention se rapporte à un variateur de vitesse et notamment à son architecture et à l'agencement de ses modules internes.

### Etat de la technique

De manière connue, un variateur de vitesse est connecté en amont à un réseau électrique et en aval à un moteur électrique. Un variateur de vitesse comporte principalement :
- en entrée, un module redresseur composé en règle générale d'un pont de diodes destiné à redresser la tension alternative fournie par le réseau électrique,
- un bus continu d'alimentation sur lequel est appliquée la tension redressée par le module redresseur, le bus continu d'alimentation étant doté d'un ou plusieurs condensateurs de bus permettant de maintenir la tension du bus à une valeur constante,
- en sortie, un module onduleur destiné à transformer la tension du bus continu en une tension variable à appliquer au moteur électrique.

Ces différents éléments sont agencés à l'intérieur d'un boîtier réalisé en deux parties. Une première partie est constituée d'un support sur lequel viennent se fixer directement ou indirectement les différents modules et composants du variateur et une deuxième partie est constituée d'un capot de fermeture venant se refermer sur le support pour fermer le boîtier.

A l'arrière, un variateur de vitesse peut comporter une semelle thermique (appelée "baseplate" en anglais) ou un refroidisseur (appelé "heat sink" en anglais) comportant un dissipateur de chaleur et un ventilateur. Lorsque les condensateurs de bus sont situés vers l'avant du variateur, ils ne sont pas refroidis directement par le refroidisseur ou par l'intermédiaire de la semelle thermique. De plus, lorsque le variateur monté sur une semelle thermique est classé par exemple IP54, IP55 ou IP66, il s'avère encore plus difficile de refroidir les condensateurs de bus car les condensateurs sont enfermés de manière étanche à l'intérieur du boîtier du variateur de vitesse. Ces difficultés de refroidissement sont susceptibles de réduire la durée de vie du variateur de vitesse.

WO 2008/071192 divulgue un variateur selon le première partie de la revendication 1.

### Exposé de l'invention

Le but de l'invention est donc de proposer un variateur de vitesse permettant un refroidissement plus aisé des condensateurs de bus, notamment lorsque le variateur de vitesse monté sur une semelle thermique est classé IP54.

Ce but est atteint par un variateur de vitesse connecté en amont à un réseau d'alimentation électrique et en aval à un moteur électrique, le variateur de vitesse comportant :
- un boîtier principal comportant un support et un capot de fermeture principal venant se refermer sur le support,
- un module redresseur inséré à l'intérieur du boîtier et destiné à redresser une tension alternative fournie par le réseau d'alimentation électrique,
- un module onduleur inséré à l'intérieur du boîtier et destiné à transformer une tension continue en une tension variable à appliquer au moteur électrique,
- un bus continu d'alimentation reliant le module redresseur au module onduleur, le bus continu d'alimentation étant doté d'un ou plusieurs condensateurs de bus permettant de maintenir la tension du bus à une valeur constante,
- le capot de fermeture principal comporte une ou plusieurs ouvertures traversées chacune par un condensateur de bus,

Le variateur de vitesse se caractérise en ce que :
- il comporte un capot de fermeture secondaire s'adaptant sur le capot de fermeture principal et recouvrant lesdits un ou plusieurs condensateurs de bus.

Selon une particularité, lesdits un ou plusieurs condensateurs de bus sont assemblés sur une carte électronique et le variateur comporte un joint découpé à la forme desdits un ou plusieurs condensateurs de bus et agencé entre ladite carte électronique et le capot de fermeture principal.

Selon une autre particularité, le capot de fermeture principal comporte un renfoncement occupé par lesdits un ou plusieurs condensateurs de bus.

Selon une autre particularité, le capot de fermeture secondaire comporte des fentes d'aération.

### Brève description des figures

D'autres caractéristiques et avantages vont apparaître dans la description détaillée qui suit en se référant à un mode de réalisation donné à titre d'exemple et représenté par les dessins annexés sur lesquels :
- la figure 1 représente un schéma électrique d'un variateur de vitesse,
- la figure 2 représente, vu en éclaté, le variateur de vitesse de l'invention,

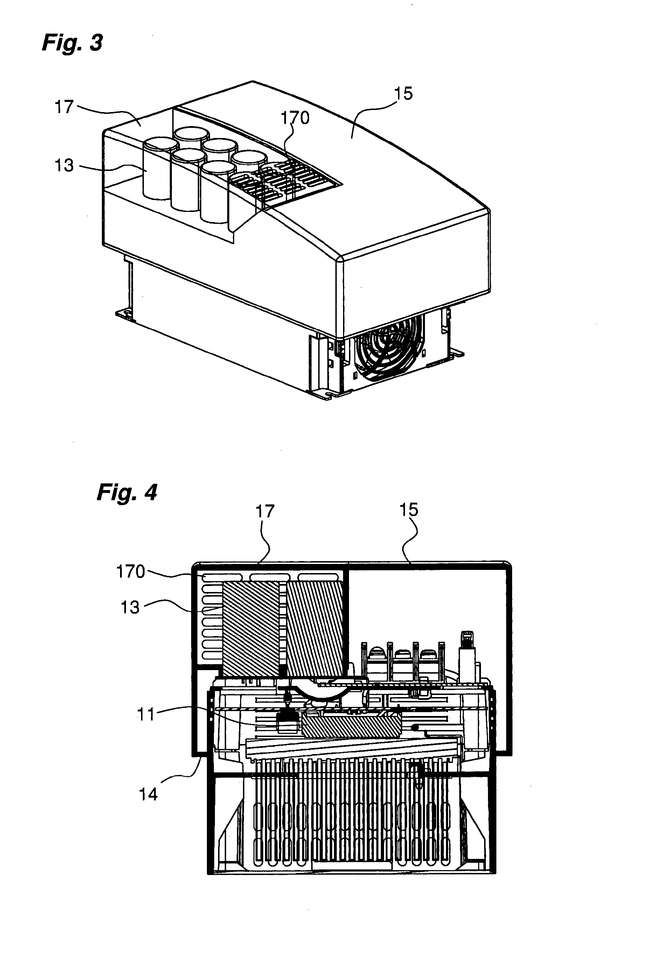

- la figure 3 représente, vu en perspective, le variateur de vitesse de l'invention,
- la figure 4 représente, vu en coupe transversale, le variateur de vitesse de l'invention.

### Description détaillée d'au moins un mode de réalisation

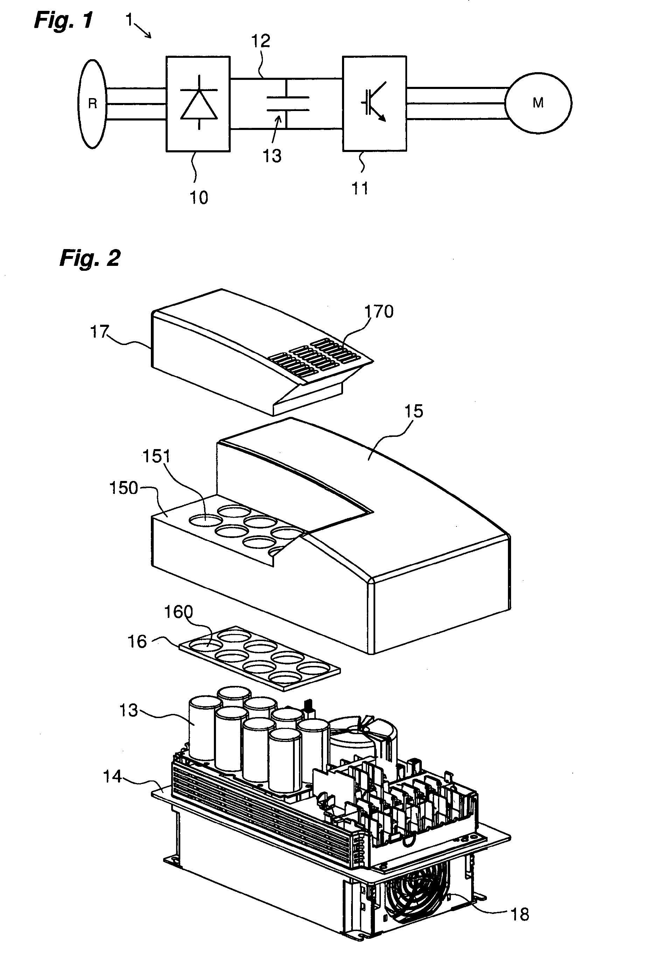

En référence à la figure 1, un variateur de vitesse 1 comporte un module redresseur 10 connecté à un réseau d'alimentation électrique R et composé en règle générale d'un pont de diodes, un module onduleur 11 comportant des interrupteurs de commutation tels que par exemple des IGBT permettant de fournir différents niveaux de tension à un moteur électrique M et un bus continu d'alimentation 12 reliant le module redresseur 10 au module onduleur 11. Le bus continu d'alimentation 12 comporte une première ligne d'alimentation à potentiel positif et une deuxième ligne d'alimentation à potentiel négatif et un ou plusieurs condensateurs de bus 13 connectés d'une part à la première ligne d'alimentation et d'autre part à la deuxième ligne d'alimentation. Dans la suite de description, on prendra l'exemple d'un variateur de vitesse qui comporte plusieurs condensateurs de bus 13.

Les différents éléments composés du module redresseur 10, du module onduleur 11 et des condensateurs de bus 13 sont assemblés sur une ou plusieurs cartes électroniques fixées sur un support 14 formant la base d'un boîtier. Le boîtier comporte également un capot de fermeture 15 principal venant s'adapter sur le support. Un ou plusieurs joints d'étanchéité peuvent être prévus pour rendre étanche la fermeture du capot de fermeture 15 principal sur le support 14 en vue de classer le variateur de vitesse IP54. Les condensateurs de bus 13 sont notamment agencés à l'avant du variateur sur une carte électronique C1 parallèle au support 14. Les condensateurs de bus 13 comportent par exemple une tête cylindrique se dressant sur leur carte électronique C1. Un système de refroidissement, tel qu'un ventilateur 18 ou une semelle thermique, situé sous le support 14, peut être prévu pour refroidir les modules situés à l'intérieur du boîtier ou faciliter les échanges thermiques. Sur les figures, le variateur de vitesse 1 est représenté avec un ventilateur 18. Il faut comprendre que l'invention est commune aux deux types d'architecture et qu'elle présente un intérêt lorsque le variateur de vitesse est monté sur une semelle thermique et qu'il est destiné à être classé IP54, IP55 ou IP66.

Le capot de fermeture 15 principal comporte par ailleurs un renfoncement 150 formé à l'extérieur. Dans ce renfoncement 150, le capot de fermeture 15 principal comporte des ouvertures 151 ayant chacune une forme adaptée pour être traversée par un condensateur de bus 13. Si les condensateurs de bus 13 présentent une section circulaire, ces ouvertures seront donc réalisées de manière circulaire. Lorsque le capot de fermeture 15 principal est en place sur le support 14, les condensateurs de bus 13 traversent les ouvertures 151 de manière à déboucher au niveau du renfoncement 150 réalisé sur le capot de fermeture 15 principal.

Pour garantir l'étanchéité du variateur de vitesse 1 et son classement IP54, IP55 ou IP66, un joint 16 est agencé entre les condensateurs de bus 13 et les bords des ouvertures 151 prévues sur le capot de fermeture 15 principal. Ce joint 16 se présente par exemple sous la forme d'une plaque en caoutchouc comportant des ouvertures 160 équivalentes aux ouvertures 151 réalisées à travers le capot de fermeture 15 principal et situées en vis-à-vis de ces ouvertures 151 afin d'être traversées par les condensateurs de bus lors de la fermeture du capot de fermeture 15 principal sur le support 14. Le joint 16 vient ainsi se plaquer contre la carte électronique C1 supportant les condensateurs de bus 13 et la face interne du capot de fermeture 15 principal vient s'appuyer contre ledit joint 16 lorsque le capot est en place sur le support 14.

Selon l'invention, le variateur de vitesse 1 comporte en outre un capot de fermeture 17 secondaire amovible destiné à venir s'adapter sur le capot de fermeture 15 principal, au niveau de son renfoncement 150 pour enfermer les condensateurs de bus 13. Le capot de fermeture secondaire présente une forme adaptée pour compléter et prolonger le capot de fermeture 15 principal autour des condensateurs de bus 13. Des moyens d'accrochage du capot de fermeture 17 secondaire au capot de fermeture 15 principal sont prévus pour réaliser la fermeture. Ce capot de fermeture secondaire comporte par exemple des fentes d'aération 170 permettant de laisser passer de l'air pour refroidir les condensateurs de bus. Ce capot de fermeture 17 secondaire permet ainsi de venir protéger les condensateurs de bus 13 tout en permettant leur aération.

L'architecture de l'invention permet ainsi de proposer un variateur de vitesse classé IP54 ne négligeant pas le refroidissement des condensateurs de bus 13.

Il est bien entendu que l'on peut, sans sortir du cadre de l'invention, imaginer d'autres variantes et perfectionnements de détail.

## Revendications

1. Variateur de vitesse (1) connecté en amont à un réseau d'alimentation électrique (R) et en aval à un moteur électrique (M), le variateur de vitesse comportant :
- un boîtier principal comportant un support (14) et un capot de fermeture (15) principal venant se refermer sur le support (14),
- un module redresseur (10) inséré à l'intérieur du boîtier et destiné à redresser une tension alternative fournie par le réseau d'alimentation électrique (R),
- un module onduleur (11) inséré à l'intérieur du boîtier et destiné à transformer une tension continue en une tension variable à appliquer au moteur électrique (M),
- un bus continu d'alimentation (12) reliant le module redresseur (10) au module onduleur (11), le bus continu d'alimentation (12) étant doté d'un ou plusieurs condensateurs de bus (13) permettant de maintenir la tension du bus à une valeur constante,
- le capot de fermeture (15) principal comporte une ou plusieurs ouvertures (151) traversées chacune par un condensateur de bus (13), le variateur de vitesse étant **caractérisé en ce que** :
- il comporte un capot de fermeture (17) secondaire s'adaptant sur le capot de fermeture (15) principal et recouvrant lesdits un ou plusieurs condensateurs de bus (13).

2. Variateur de vitesse selon la revendication 1, **caractérisé en ce que** lesdits un ou plusieurs condensateurs de bus (13) sont assemblés sur une carte électronique (C1) et **en ce que** le variateur comporte un joint (16) découpé à la forme desdits un ou plusieurs condensateurs de bus (13) et agencé entre ladite carte électronique (C1) et le capot de fermeture (15) principal.

3. Variateur de vitesse selon la revendication 1 ou 2, **caractérisé en ce que** le capot de fermeture (15) principal comporte un renfoncement (150) occupé par lesdits un ou plusieurs condensateurs de bus (13).

4. Variateur de vitesse selon la revendication 1, **caractérisé en ce que** le capot de fermeture (17) secondaire comporte des fentes d'aération (170).

## Patentansprüche

1. Drehzahlregler (1), der vorne mit einem Stromversorgungsnetz (R) und hinten mit einem Elektromotor (M) verbunden ist, wobei der Drehzahlregler aufweist:
- ein Hauptgehäuse, das einen Träger (14) und eine Hauptverschlusskappe (15) aufweist, die sich auf dem Träger (14) schließt,
- ein Gleichrichtermodul (10), das ins Innere des Gehäuses eingefügt und dazu bestimmt ist, eine vom Stromversorgungsnetz (R) gelieferte Wechselspannung gleichzurichten,
- ein Wechselrichtermodul (11), das ins Innere des Gehäuses eingefügt und dazu bestimmt ist, eine Gleichspannung in eine variable Spannung umzuwandeln, die an den Elektromotor (M) angelegt werden soll,
- ein Gleichstromversorgungsbus (12), der das Gleichrichtermodul (10) mit dem Wechselrichtermodul (11) verbindet, wobei der Gleichstromversorgungsbus (12) mit einem oder mehreren Buskondensatoren (13) versehen ist, die es ermöglichen, die Spannung des Busses auf einem konstanten Wert zu halten,
- die Hauptverschlusskappe (15) eine oder mehrere Öffnungen (151) aufweist, die je von einem Buskondensator (13) durchquert werden,
wobei der Drehzahlregler **dadurch gekennzeichnet ist, dass**:
- er eine Sekundärverschlusskappe (17) aufweist, die sich auf die Hauptverschlusskappe (15) anpasst und die mehreren Buskondensatoren (13) bedeckt.

2. Drehzahlregler nach Anspruch 1, **dadurch gekennzeichnet, dass** der eine oder die mehreren Buskondensatoren (13) auf einer Elektronikkarte (C1) zusammengefügt sind, und dass der Regler eine Dichtung (16) aufweist, die auf die Form des einen oder der mehreren Buskondensatoren (13) zugeschnitten und zwischen der Elektronikkarte (C1) und der Hauptverschlusskappe (15) angeordnet ist.

3. Drehzahlregler nach Anspruch 1 oder 2, **dadurch gekennzeichnet, dass** die Hauptverschlusskappe (15) eine Vertiefung (150) aufweist, die von dem einen oder den mehreren Buskondensatoren (13) belegt wird.

4. Drehzahlregler nach Anspruch 1, **dadurch gekennzeichnet, dass** die Sekundärverschlusskappe (17) ein Belüftungsfenster (170) aufweist.

## Claims

1. Variable speed drive (1) connected upstream to an electric power grid (R) and downstream to an electric motor (M), the variable speed drive comprising:
- a main casing comprising a base (14) and a main closure cover (15) closing on the base (14),
- a rectifier module (10) inserted inside the casing and designed to rectify an AC voltage supplied by the electric power grid (R),
- an inverter module (11) inserted inside the casing and designed to transform a DC voltage into a variable voltage to be applied to the electric motor (M),
- a DC power supply bus (12) connecting the rectifier module (10) to the inverter module (11), the DC power supply bus (12) being furnished with one or more bus capacitors (13) making it possible to keep the voltage of the bus at a constant value,
- the main closure cover (15) comprises one or more openings (151) each traversed by a bus capacitor (13),
the variable speed drive being **characterized in that**:
- it comprises a secondary closure cover (17) fitting onto the main closure cover (15) and covering the said one or more bus capacitors (13).

2. Variable speed drive according to Claim 1, **characterized in that** the said one or more bus capacitors (13) are assembled on an electronic circuit board (C1) and **in that** the variable speed drive comprises a seal (16) cut out to the shape of the said one or more bus capacitors (13) and arranged between the said electronic circuit board (C1) and the main closure cover (15).

3. Variable speed drive according to Claim 1 or 2, **characterized in that** the main closure cover (15) comprises a recess (150) occupied by the said one or more bus capacitors (13).

4. Variable speed drive according to Claim 1, **characterized in that** the secondary closure cover (17) comprises aeration slots (170).
